# EUROPEAN PATENT APPLICATION

(11) **EP 2 637 307 A1**
(43) Date of publication of application: **11.09.2013**
(21) Application number: 12161910.0
(22) Date of filing: 28.03.2012
(51) Int. Cl.: H03K 17/60, H03G 3/34, H03F 1/30, H03K 19/09

(54) **Mute drive circuit**

(30) Priority: 09.03.2012 CN 201210061565
(71) Applicant: Hong Fu Jin Precision Industry (ShenZhen) Co., Ltd., Shenzhen City, Guangdong 518109 (CN); Hon Hai Precision Industry Co., Ltd., New Taipei City (TW)
(72) Inventor: Ma, Bin-Song, Shenzhen City, Guangdong Province (CN); Kao, Hsing-Suang, Tu-Cheng, New Taipei (TW)
(74) Representative: Gray, John James

(57) **Abstract**

A mute drive circuit (10) includes a micro-controller (12) including an I/O port (122); a mute circuit (16); and an npn transistor (14). When an electronic device using the mute circuit is plugged into an AC power source, the I/O port is set to the logic low, the mute circuit performs the mute mode. When the electronic device is turned on, the I/O port is controlled set to the logic low for a period and then be pulled up to the logic high, the mute circuit performs the mute mode for the period and then enters into the normal mode. When the electronic device is turned off, the I/O port is controlled to set to the logic low, the mute circuit performs the mute mode. When the electronic device is unplugged from the AC power source, the I/O port is pulled down to the logic low, the mute circuit performs the mute mode.

## Description

### BackGround

The present disclosure relates to mute drive circuits, and more particularly to a mute drive circuit for eliminating noise generated by plugging or unplugging into/out of an AC power source or implementing a turning on/off operation.

### 2. Description of Related Art

Noise such as a popping sound and/or static is familiar to people during plugging in or out power supply and implementing turning on or off operation on multimedia electronic devices, such as MP3 and mobile phones. A method to eliminate or suppress such noise is using a tank circuit connected to the power supply for releasing energy when the power is suddenly decreased or increased, thereby a mute mode could be performed for a period to eliminate the POP noise. However, the tank circuit needs two transistors and an electrolytic capacitor, and so is costly.

### BRIEF DESCRIPTION OF THE DRAWINGS

The components in the drawings are not necessarily drawn to scale, the emphasis instead being placed upon clearly illustrating the principles of the mute drive circuit for eliminating noise generated by plugging or unplugging into/out of an AC power source or implementing a turning on/off operation.

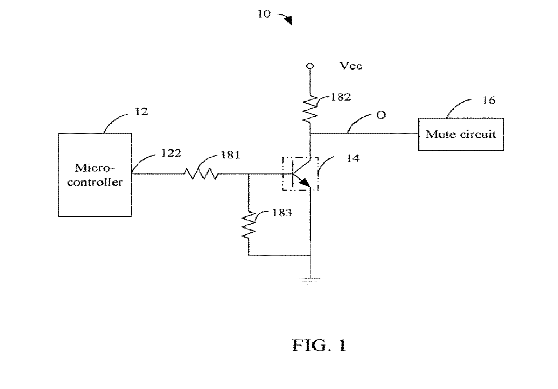

The drawing is a schematic circuit diagram of one embodiment of mute drive circuit in accordance with the present disclosure.

### DETAILED DESCRIPTION

The disclosure is illustrated by way of example and not by way of limitation in the figures of the accompanying drawings in which like references indicate similar elements. It should be noted that references to "an" or "one" embodiment in this disclosure are not necessarily to the same embodiment, and such references mean at least one.

The mute circuit 10 can be applied in multimedia electronic devices, such as MP3 and mobile phones. Referring to the drawing, the mute drive circuit 10 includes a micro-controller 12, a switch such as an npn transistor 14, a mute circuit 16, a first voltage-dividing resistance 181, a second voltage-dividing resistance 182, and a current-limiting resistance 183.

The micro-controller 12 includes an I/O port 122. The I/O port 22 is a GPRO port. When the electronic device using the mute circuit 10 is plugged into an AC power source, a system voltage Vcc is connected and the I/O port 22 is set to a logic low. When the electronic device is turned on, the I/O port 22 is controlled by the micro-controller 12 through software to be logic low for a period and then pulled up to a logic high. When the electronic device is turned off, the I/O port 22 is controlled by the micro-controller 12 through software to be logic low. When the electronic device using the mute circuit 10 is unplugged from the AC power source, as a decreasing rate of voltage of the I/O port 22 is faster than a decreasing rate of voltage of the system voltage Vcc, therefore the system voltage Vcc is read as logic high and the I/O port 22 as logic low. The system voltage Vcc can be considered as logic high and the I/O port 22 is logic low when, for example, the voltage of the system voltage Vcc is above 0.7V.

A base of the npn transistor 14 is connected with the I/O port 22 of the micro-controller 12 via the first voltage-dividing resistance 183, and is grounded via the second voltage-dividing resistance 181. An emitter of the npn transistor 14 is grounded. A connector of the npn transistor 14 is connected with the system voltage Vcc via the current-limiting resistance 183, and connected with the mute circuit 16 forming the control port O of the mute circuit 16.

When the I/O port 22 is pulled down to a logic low, the npn transistor 14 is turned off, which makes the control port O of the mute circuit 16 connect to the system voltage Vcc, that is to say, the control port O is set to the logic high. When the I/O port 22 is pulled up to a logic high, the npn transistor 14 is turned on, which makes the control port O of the mute circuit 16 connect to ground, that is to say, the control port O is set to the logic low.

The mute circuit 16 performs the mute mode when the control port O is set to a logic high, and performs the normal mode when the control port O is set to the logic low.

When the electronic device using the mute circuit 10 is plugged into an AC power source , the I/O port 122 is pulled down to the logic low, that is to say, the control port O is set to the logic high, and the mute circuit 16 performs the mute mode. When the electronic device is turned on, the I/O port 122 is controlled by the micro-controller 12 to keep to be logic low for a period and then be pulled up to the logic high, that is to say, the control port O is set to the logic low for a period and then pulled up to the logic high, the mute circuit 16 performs the mute mode for a period and then enters into the normal mode. When the electronic device is turned off, the I/O port 122 is controlled by the micro-controller12 to be logic low, that is to say, the control port O is set to the logic high, and the mute circuit 16 performs the mute mode. When the electronic device using the mute circuit 10 is unplugged from the AC power source, the system voltage Vcc is pulled up to the logic high, and the I/O port 122 is pulled down to the logic low, that is to say, the control port O is pulled down to the logic high, the mute circuit 16 performs the mute mode.

The mute drive circuit 10 uses hardware characteristics of the micro-controller, the system voltage VCC, and the I/O port to control the mute circuit 16 to perform the mute mode, thereby eliminating noise generated by plugging or unplugging into/out of the AC power source or implementing the turning on/off operation.

Although the current disclosure has been specifically described on the basis of the exemplary embodiment thereof, the disclosure is not to be construed as being limited thereto. Various changes or modifications may be made to the embodiment without departing from the scope and spirit of the disclosure.

## Claims

1. A mute drive circuit comprising:
a micro-controller comprising an I/O port;
a mute circuit comprising a control port, performing a mute mode when the control port is pulled up to a logic high, and performing a normal mode when the control port is set to a logic low;
a switch, being turned off when the I/O port is set to a logic high to make the control port of the mute circuit connect to a system voltage, thereby being pulled up to the logic high, being turned on when the I/O port is set to the logic low to make the control port of the mute circuit to connect to ground, thereby being set to the logic low;
wherein when an electronic device using the mute circuit is plugged into an AC power source, the system voltage is connected, the I/O port is set to the logic low, the control port is set to the logic high, the mute circuit performs the mute mode, when the electronic device is turned on, the I/O port is controlled by the micro-controller to set to the logic low for a period and then be pulled up to the logic high, the control port is set to the logic low for the period and then pulled up to the logic high, the mute circuit performs the mute mode for the period and then enters into the normal mode, when the electronic device is turned off, the I/O port is controlled by the micro-controller to keep logic low, the control port is set to the logic high, the mute circuit performs the mute mode, when the electronic device is unplugged from the AC power source, the system voltage is pulled up to the logic high, and the I/O port is pulled down to the logic low, the control port is pulled down to the logic high, the mute circuit performs the mute mode.

2. The mute drive circuit of claim 1, wherein the switch comprises a npn type transistor, a base of the npn transistor is connected with the I/O port via a first voltage-dividing resistance, and is grounded via a second voltage-dividing resistance, an emitter of the npn transistor is grounded, a connector of the npn transistor is connected with the system voltage via a current-limiting resistance, and is connected with the control port of the mute circuit.

3. The mute drive circuit of claim 1, wherein the I/O port is a GPRO port.

4. The mute drive circuit of claim 1, wherein when the electronic device is turned on, the I/O port is controlled by the micro-controller through software to set to the logic low for a period and then pulled up to the logic high, when the electronic device is turned off, the I/O port is controlled by the micro-controller through software to set to the logic low.

5. The mute drive circuit of claim 1, wherein the system voltage is read as logic high and the I/O port as logic low when the voltage of the system voltage is above 0.7V.
